# EUROPEAN PATENT APPLICATION

(11) **EP 4 790 900 A1**
(43) Date of publication of application: **12.08.2026**
(21) Application number: 24938120.3
(22) Date of filing: 20.12.2024
(51) Int. Cl.: H03K 7/08

(54) **SIGNAL PROCESSING METHOD, CIRCUIT AND CHIP, AND ELECTRONIC DEVICE**

(71) Applicant: SHENZHEN GOODIX TECHNOLOGY CO., LTD., Shenzhen, Guangdong 518045 (CN)
(72) Inventor: LI, Bohao, Shenzhen, Guangdong 518045 (CN); YANG, Yuqing, Shenzhen, Guangdong 518045 (CN); PENG, Jiangyang, Shenzhen, Guangdong 518045 (CN)
(74) Representative: Kraus & Lederer PartGmbB
(86) International application number: PCT/CN2024/141117
(87) International publication number: WO 2026/129319

(57) **Abstract**

Embodiments of the present application provide a signal processing method, circuit, and chip and an electronic device. The signal processing method includes: processing an input digital signal based on a PWM synchronization clock signal to obtain an analog differential signal; performing chopping processing on an intermediate common-mode voltage signal based on a chopping clock signal to obtain a common-mode voltage signal, where the intermediate common-mode voltage signal is used to stabilize a common-mode voltage of the analog differential signal, and an edge of a pulse included in the chopping clock signal is not aligned with an edge of a pulse included in the PWM synchronization clock signal in a time sequence; performing noise shaping and then PWM modulation on the analog differential signal to obtain a PWM signal; and performing voltage domain conversion on the PWM signal to obtain an output signal. This solution can improve signal processing performance.

## Description

### TECHNICAL FIELD

Embodiments of the present application relate to the field of electronic technologies, and in particular, to a signal processing method, circuit, and chip and an electronic device.

### BACKGROUND

Pulse-width modulation (PWM) is a technology for controlling an analog circuit by using a digital output of a microprocessor. A required waveform (including a shape and an amplitude) is obtained by modulating a pulse width, that is, a voltage and a frequency are adjusted by changing a duty cycle. A class D power amplifier (also referred to as a digital power amplifier or a switching power amplifier) using the PWM technology is often used to amplify audio signals.

Currently, when an input of the class D power amplifier is a digital signal, the digital signal is converted into an analog signal, and PWM modulation is performed based on the analog signal to generate a PWM signal.

However, when an operating voltage of a chip in which the class D power amplifier is located is high, a signal fed back by the class D power amplifier to a signal chain or an analog loop filter includes a large common-mode feedback current, and the existence of the common-mode feedback current causes large distortion, thereby resulting in poor performance of the class D power amplifier.

### SUMMARY

In view of this, embodiments of the present application provide a signal processing method, circuit, and chip and an electronic device, to at least partially resolve the foregoing problem.

According to a first aspect of the embodiments of the present application, a signal processing method is provided, including: processing an input digital signal based on a PWM synchronization clock signal to obtain an analog differential signal; performing chopping processing on an intermediate common-mode voltage signal based on a chopping clock signal to obtain a common-mode voltage signal, where the intermediate common-mode voltage signal is used to stabilize a common-mode voltage of the analog differential signal, and an edge of a pulse included in the chopping clock signal is not aligned with an edge of a pulse included in the PWM synchronization clock signal in a time sequence; performing noise shaping and then PWM modulation on the analog differential signal to obtain a PWM signal; and performing voltage domain conversion on the PWM signal to obtain an output signal.

According to a second aspect of the embodiments of the present application, a signal processing circuit is provided, including: a digital signal processor, configured to process an input digital signal based on a PWM synchronization clock signal to obtain an analog differential signal; a chopper, configured to perform chopping processing on an intermediate common-mode voltage signal based on a chopping clock signal to obtain a common-mode voltage signal, where the intermediate common-mode voltage signal is used to stabilize a common-mode voltage of the analog differential signal, and an edge of a pulse included in the chopping clock signal is not aligned with an edge of a pulse included in the PWM synchronization clock signal in a time sequence; a modulation module, configured to perform noise shaping and then PWM modulation on the analog differential signal to obtain a PWM signal; and a power output module, configured to perform voltage domain conversion on the PWM signal to obtain an output signal.

According to a third aspect of the embodiments of the present application, a signal processing chip is provided. The signal processing chip is configured to perform the method according to the foregoing first aspect.

According to a fourth aspect of the embodiments of the present application, an electronic device is provided, including: a signal source, a signal receiving end, and a signal processing apparatus, where the signal processing apparatus includes the signal processing circuit according to the foregoing second aspect or the signal processing chip according to the foregoing third aspect; the signal processing apparatus is connected between the signal source and the signal receiving end; the signal source is configured to transmit an input digital signal to the signal processing apparatus; and the signal receiving end is configured to receive an output signal output by the signal processing apparatus.

According to solutions in the embodiments of the present application, an input digital signal is processed based on a PWM synchronization clock signal to obtain an analog differential signal, and chopping processing is performed on an intermediate common-mode signal based on a chopping clock signal to obtain a common-mode voltage signal. The common-mode voltage signal can stabilize a common-mode voltage of the analog differential signal, and an edge of a pulse included in the chopping clock signal is not aligned with an edge of a pulse included in the PWM synchronization clock signal in a time sequence. In this way, the arrival of a pulse included in the analog differential signal at an input common-mode point and chopping frequency switching do not occur simultaneously, that is, before the pulse included in the analog differential signal arrives at the input common-mode point, there is a certain period of time to stabilize the intermediate common-mode voltage signal, thereby ensuring a suppression effect on noise and harmonic waves when noise shaping is performed on the analog differential signal, and ensuring that the analog differential signal is sent into a noise shaping filter without loss and distortion. Further, after a PWM signal is obtained by performing PWM modulation on the analog differential signal after noise shaping, the PWM signal includes less noise and harmonic waves, and then after an output signal is obtained by performing voltage domain conversion on the PWM signal, the output signal includes less noise and harmonic waves, to ensure signal processing performance.

### BRIEF DESCRIPTION OF DRAWINGS

To describe the technical solutions in the embodiments of the present application or in the conventional technology more clearly, the following briefly describes the accompanying drawings for describing the embodiments or the conventional technology. It is clear that the accompanying drawings in the following description are merely some embodiments recorded in the embodiments of the present application, and those of ordinary skill in the art may still derive other drawings from these accompanying drawings.
FIG. 1 is a flowchart of a signal processing method according to an embodiment of the present application;
FIG. 2 is a schematic diagram of a chopping clock signal and a PWM synchronization clock signal according to an embodiment of the present application;
FIG. 3 is a schematic diagram of a chopping clock signal and a PWM synchronization clock signal according to another embodiment of the present application;
FIG. 4 is a schematic diagram of a clock signal according to an embodiment of the present application;
FIG. 5 is a schematic diagram of a signal processing circuit according to an embodiment of the present application;
FIG. 6 is a schematic diagram of a signal processing circuit according to another embodiment of the present application;
FIG. 7 is a schematic diagram of a signal processing circuit according to still another embodiment of the present application;
FIG. 8 is a schematic diagram of an input common-mode feedback buffer amplifier according to an embodiment of the present application; and
FIG. 9 is a schematic diagram of an electronic device according to an embodiment of the present application.

### DETAILED DESCRIPTION

To enable those skilled in the art to better understand the technical solutions in the embodiments of the present application, the following clearly and completely describes the technical solutions in the embodiments of the present application with reference to the accompanying drawings in the embodiments of the present application. It is clear that the described embodiments are only a part rather than all of the embodiments of the present application. Based on the embodiments in the embodiments of the present application, all other embodiments obtained by those of ordinary skill in the art shall fall within the protection scope of the embodiments of the present application.

The terms used in the present application are for the sole purpose of describing specific embodiments and are not intended to limit the present application. The terms "one", "the", and "this" of singular forms used in the present application and the appended claims are also intended to include plural forms, unless otherwise specified in the context clearly. It should be further understood that the term "and/or" used herein indicates and includes any or all possible combinations of one or more associated listed items.

It should be understood that although the terms "first", "second", "third", and the like may be used in the present application to describe various types of information, the information should not be limited to these terms. These terms are only used to distinguish between information of a same type. For example, without departing from the scope of the present application, "first information" may also be referred to as "second information", and similarly, "second information" may also be referred to as "first information". Depending on the context, for example, the word "if" used herein can be interpreted as "while", "when", or "in response to determining".

To make the objectives, the technical solutions, and the advantages of the present application clearer, the following further describes the embodiments the present application in detail with reference to the accompanying drawings.

### Signal Processing Method

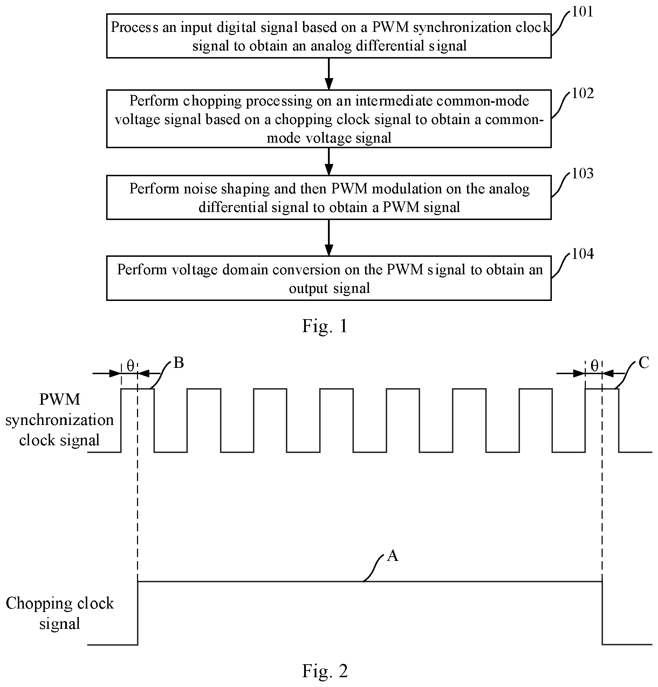

FIG. 1 is a flowchart of a signal processing method according to an embodiment of the present application. As shown in FIG. 1, the signal processing method includes the following steps:
Step 101: Process an input digital signal based on a PWM synchronization clock signal to obtain an analog differential signal.

The digital signal may be a digital audio signal. For example, the digital signal may be a digital audio signal transmitted by an upper computer through an integrated circuit internal audio bus (Inter-IC Sound, I2S).

In an example, a digital audio processor (DAP) may be used to preprocess (such as noise shaping) the digital signal, and convert the preprocessed digital signal into an analog signal to obtain an analog differential signal. The digital audio processor is a digital signal processor (DSP). The analog differential signal includes a positive analog differential signal and a negative analog differential signal. The positive analog differential signal and the negative analog differential signal are digital PWM waves. The pulse widths of differential mode signals of the positive analog differential signal and the negative analog differential signal may indicate the magnitude of the digital signal. For example, the pulse widths of the differential mode signals of the positive analog differential signal and the negative analog differential signal are positively correlated with a semaphore of the digital signal. The magnitude of the digital signal may be directly mapped by using duty cycles of the PWM waves. For example, if an input digital signal value is large, a high-level time of the PWM signal in a period may be longer. If the signal value is small, the high-level time is shorter. The main purpose of using the analog differential signal is to improve an anti-interference capability.

The PWM synchronization clock signal is used for synchronizing the analog differential signal, that is, synchronizing the positive analog differential signal and the negative analog differential signal. When the digital signal is processed by the DAP, the PWM synchronization clock signal and the digital signal are input to the DAP. After preprocessing the digital signal, the DAP converts the preprocessed digital signal into a positive analog differential signal and a negative analog differential signal, and outputs the positive analog differential signal and the negative analog differential signal after synchronizing them based on the PWM synchronization clock signal.

Step 102: Perform chopping processing on an intermediate common-mode voltage signal based on a chopping clock signal to obtain a common-mode voltage signal.

Chopping processing is performed on the intermediate common-mode voltage signal based on the chopping clock signal to obtain the common-mode voltage signal, where the intermediate common-mode voltage signal is used to stabilize a common-mode voltage of the analog differential signal. By performing chopping processing on the intermediate common-mode voltage signal, flicker noise (also referred to as 1/f noise) included in the intermediate common-mode voltage signal may be modulated out of an audio frequency band range, to improve a signal-to-noise ratio (SNR) of the processed audio signal.

The intermediate common-mode voltage signal may include a positive intermediate common-mode voltage signal and a negative intermediate common-mode voltage signal, and the positive intermediate common-mode voltage signal and the negative intermediate common-mode voltage signal are the same. The intermediate common-mode voltage signal may be generated in a feedback manner, so that the positive intermediate common-mode voltage signal and the negative intermediate common-mode voltage signal approach a common-mode voltage reference signal.

In an example, the common-mode voltage reference signal is a direct current signal of 2.7 V, the positive intermediate common-mode voltage signal and the negative intermediate common-mode voltage signal are approximately straight waves, that is, the positive intermediate common-mode voltage signal and the negative intermediate common-mode voltage signal are direct current voltage signals approaching 2.7 V.

Because an operating voltage range of a chip includes a low voltage to a high voltage, large common-mode feedback currents are generated when the chip operates at a high voltage. These common-mode feedback currents can be absorbed by an input common-mode feedback buffer amplifier that generates the intermediate common-mode voltage signal, to ensure common-mode voltage stability of the analog differential signal, that is, the common-mode voltage signal is used to stabilize the common-mode voltage of the analog differential signal. An analog circuit needs a proper operating point. The input common-mode feedback buffer amplifier can stabilize a common mode of an input common-mode point. By stabilizing the common-mode voltage of the analog differential signal by the common-mode voltage signal, a loss of the analog differential signal can be reduced, to improve performance of the processed audio signal.

In an example, a positive common-mode voltage signal can be obtained by performing chopping processing on the positive common-mode voltage signal, and a negative common-mode voltage signal can be obtained by performing chopping processing on the negative common-mode voltage signal. The positive common-mode voltage signal is coupled to the positive analog differential signal, and the negative common-mode voltage signal is coupled to the negative analog differential signal, to stabilize common-mode voltages of the positive analog differential signal and the negative analog differential signal.

In an example, the DAP outputs an analog differential signal to an analog loop filter (ALF), and the ALF performs noise shaping and then PWM modulation on the analog differential signal to obtain a PWM signal. The input common-mode feedback buffer amplifier (Input CMFB buffer amplifier) processes the common-mode voltage reference signal to obtain an intermediate common-mode voltage signal. A chopper performs chopping processing on the intermediate common-mode voltage signal based on the chopping clock signal to obtain the common-mode voltage signal. The common-mode voltage signal is a common-mode signal at an input end of the ALF. The PWM synchronization clock signal is used to synchronize an output signal of the DAP, and the chopping clock signal is used to drive the chopper.

At a moment of a leading edge of a pulse included in the PWM synchronization clock signal, the DAP outputs a pulse to an input common-mode point (virtual location) of the ALF. The chopper is also connected to the input common-mode point. When a chopping frequency of the chopper switches over an edge of the chopping clock signal, the input common-mode feedback buffer amplifier needs time to maintain stable. If an edge of the pulse included in the PWM synchronization clock signal is aligned with an edge of a pulse included in the chopping clock signal in a time sequence, the switching of the chopping frequency occurs simultaneously with the DAP outputting a pulse. In this case, the output of the input common-mode feedback buffer amplifier is not stable, which results in a decrease in the impedance of the input common-mode point and a decrease in suppression of noise and harmonic waves by a loop, thereby reducing signal processing performance. Therefore, the edge of the pulse included in the chopping clock signal is not aligned with the edge of the pulse included in the PWM synchronization clock signal in a time sequence, that is, the chopping clock signal and the PWM synchronization clock signal are staggered by a specific phase. A leading edge of the pulse included in the chopping clock signal is not aligned with the leading edge and a trailing edge of the pulse included in the PWM synchronization clock signal in a time sequence, and a trailing edge of the pulse included in the chopping clock signal is not aligned with both the leading edge and the trailing edge of the pulse included in the PWM synchronization clock signal in a time sequence. Before a pulse output by the DAP arrives at an input common-mode point, there is a certain period of time to stabilize the output of the input common-mode feedback buffer amplifier, thereby ensuring a suppression effect of the loop on noise and harmonic waves, and ensuring signal processing performance.

Step 103: Perform noise shaping and then PWM modulation on the analog differential signal to obtain a PWM signal.

By performing noise shaping on the analog differential signal, high-order PWM modulation harmonic waves in the analog differential signal can be filtered out, and by performing PWM modulation on the analog differential signal after noise shaping, the PWM signal can be obtained. The PWM signal includes a PWM positive signal and a PWM negative signal.

In one example, the analog differential signal includes a positive analog differential signal and a negative analog differential signal, and the positive analog differential signal and the negative analog differential signal are coupled to the input end of the ALF, and are sent to a comparator for comparison with a triangular wave after noise shaping, and then logic processing is performed on a comparison result to obtain a PWM positive signal and a PWM negative signal.

Step 104: Perform voltage domain conversion on the PWM signal to obtain an output signal.

After the PWM signal is obtained, voltage domain conversion may be performed on the PWM signal to obtain the output signal. The output signal may include a positive output signal and a negative output signal. A function of voltage domain conversion is to change the amplitude of the PWM signal and keep the duty cycle of the PWM signal unchanged. For example, the amplitude of the PWM signal is 2.7 V, and the duty cycle is 30%. By performing voltage domain conversion on the PWM signal, the amplitude of the obtained output signal is 24 V, and the duty cycle of the obtained output signal is 30%. In an example, when the digital signal is a digital audio signal, the output signal may be used to drive a speaker after filtering processing (for example, LC filtering or low-pass filtering).

In this embodiment of the present application, an input digital signal is processed based on a PWM synchronization clock signal to obtain an analog differential signal, and chopping processing is performed on an intermediate common-mode signal based on a chopping clock signal to obtain a common-mode voltage signal. The common-mode voltage signal can stabilize a common-mode voltage of the analog differential signal, and an edge of a pulse included in the chopping clock signal is not aligned with an edge of a pulse included in the PWM synchronization clock signal in a time sequence. In this way, the arrival of a pulse included in the analog differential signal at an input common-mode point and chopping frequency switching do not occur simultaneously, that is, before the pulse included in the analog differential signal arrives at the input common-mode point, there is a certain period of time to stabilize the intermediate common-mode voltage signal, thereby ensuring a suppression effect on noise and harmonic waves when noise shaping is performed on the analog differential signal. Further, after a PWM signal is obtained by performing PWM modulation on the analog differential signal after noise shaping, the PWM signal includes less noise and harmonic waves, and then after an output signal is obtained by performing voltage domain conversion on the PWM signal, the output signal includes less noise and harmonic waves, to ensure signal processing performance.

In a possible implementation, a leading edge of the pulse included in the chopping clock signal is located between a leading edge and a trailing edge of a first pulse included in the PWM synchronization clock signal in a time sequence, and a phase delay of the leading edge of the pulse included in the chopping clock signal relative to the leading edge of the first pulse is [45°, 135°].

For any pulse included in the chopping clock signal, the first pulse is a pulse corresponding to the pulse in a time sequence in the PWM synchronization clock signal, a leading edge of the pulse is located between the leading edge and the trailing edge of the corresponding first pulse in a time sequence, and a phase delay of the leading edge of the pulse relative to the leading edge of the corresponding first pulse is [45°, 135°].

The pulse included in the chopping clock signal may be either at a low level or a high level. In the chopping clock signal, if the pulse is at a low level, the leading edge of the pulse is a falling edge, and the trailing edge of the pulse is a rising edge. If the pulse is at a high level, the leading edge of the pulse is a rising edge, and the trailing edge of the pulse is a falling edge.

The pulse included in the PWM synchronization clock signal may be either at a low level or a high level. In the PWM synchronization clock signal, if the pulse is at a low level, the leading edge of the pulse is a falling edge, and the trailing edge of the pulse is a rising edge. If the pulse is at a high level, the leading edge of the pulse is a rising edge, and the trailing edge of the pulse is a falling edge. The pulse included in the chopping clock signal may be either at a low level or a high level.

For example, both the pulse included in the chopping clock signal and the pulse included in the PWM synchronization clock signal are at a high level. FIG. 2 shows a schematic diagram of a chopping clock signal and a PWM synchronization clock signal according to an embodiment of the present application. As shown in FIG. 2, a pulse A included in the chopping clock signal and a pulse B included in the PWM synchronization clock signal are two pulses corresponding to each other in a time sequence. A rising edge of the pulse A is located between a rising edge and a falling edge of the pulse B in a time sequence, and a phase delay of the rising edge of the pulse A relative to the rising edge of the pulse B is θ, where 45°≤θ≤135°.

It should be noted that a frequency of the PWM synchronization clock signal is an integer multiple of a frequency of the chopping clock signal. When the leading edge of the pulse included in the chopping clock signal is located between a leading edge and a trailing edge of a certain pulse included in the PWM synchronization clock signal in a time sequence, a trailing edge of the pulse included in the chopping clock signal is located between a leading edge and a trailing edge of a fourth pulse included in the PWM synchronization clock signal in a time sequence, and a phase delay of the trailing edge of the pulse included in the chopping clock signal relative to the leading edge of the fourth pulse is the same as a phase delay of the leading edge of the pulse included in the chopping clock signal relative to the leading edge of the first pulse, that is, a phase delay of the trailing edge of the pulse included in the chopping clock signal relative to the leading edge of the fourth pulse is [45°, 135°]. The fourth pulse is located after the first pulse in a time sequence, and the first pulse and the fourth pulse may be adjacent pulses in the PWM synchronization clock signal, or there is one or more pulses between the first pulse and the fourth pulse.

As shown in FIG. 2, the rising edge of the pulse A is located between the rising edge and the falling edge of the pulse B in a time sequence, and the phase delay of the rising edge of the pulse A relative to the rising edge of the pulse B is θ. A falling edge of the pulse A is between a rising edge and a falling edge of a pulse C, and a phase delay of the falling edge of the pulse A relative to the rising edge of the pulse C is θ.

In this embodiment of the present application, the leading edge of the pulse included in the chopping clock signal is located between the leading edge and the trailing edge of the first pulse included in the PWM synchronization clock signal in a time sequence, and the phase delay of the leading edge of the pulse included in the chopping clock signal relative to the leading edge of the first pulse is [45°, 135°]. The PWM synchronization clock signal is used to synchronize the analog differential signal, to ensure that the arrival of the pulse included in the analog differential signal at the input common-mode point and chopping frequency switching of the chopping clock signal do not occur simultaneously, and before the pulse included in the analog differential signal arrives at the input common-mode point, there is enough time to stabilize the intermediate common-mode voltage signal, thereby ensuring a suppression effect on noise and harmonic waves when noise shaping is performed on the analog differential signal.

In a possible implementation, a phase delay of the leading edge of the pulse included in the chopping clock signal relative to the leading edge of the first pulse is 90°.

The leading edge of the pulse included in the chopping clock signal is located between the leading edge and the trailing edge of the first pulse in the PWM synchronization clock signal in a time sequence. When the leading edge of the pulse included in the chopping clock signal is aligned with the leading edge of the first pulse in a time sequence, the phase delay of the leading edge of the pulse included in the chopping clock signal relative to the leading edge of the first pulse is 0, and when the leading edge of the pulse included in the chopping clock signal is aligned with the trailing edge of the first pulse in a time sequence, the phase delay of the leading edge of the pulse included in the chopping clock signal relative to the leading edge of the first pulse is 180°.

As shown in FIG. 2, when the leading edge of the pulse A is aligned with the leading edge of the pulse B in a time sequence, θ is equal to 0, and when the leading edge of the pulse A is aligned with the trailing edge of the pulse B in a time sequence, θ is equal to 180°.

In this embodiment of the present application, the phase delay of the leading edge of the pulse included in the chopping clock signal relative to the leading edge of the first pulse in the PWM synchronization clock signal is 90°, both a phase difference between the leading edge of the pulse included in the chopping clock signal and the leading edge of the first pulse and a phase difference between the leading edge of the pulse included in the chopping clock signal and the trailing edge of the first pulse are 90°, and the leading edge of the pulse included in the chopping clock signal has large phase differences with the leading edge and the trailing edge of the first pulse at the same time. In this way, while ensuring that the arrival of the pulse included in the analog differential signal at the input common-mode point and the chopping frequency switching do not occur simultaneously, there is enough time to stabilize the intermediate common-mode voltage signal, thereby avoiding an impedance drop of the input common-mode point, and further ensuring a suppression effect on noise and harmonic waves when noise shaping is performed on the analog differential signal.

In a possible implementation, the leading edge of the pulse included in the chopping clock signal is located between a trailing edge of a second pulse and a leading edge of a third pulse included in the PWM synchronization clock signal in a time sequence, and a phase delay of the leading edge of the pulse included in the chopping clock signal relative to the trailing edge of the second pulse is [45°, 135°]. In the PWM synchronization clock signal, the second pulse and the third pulse are pulses adjacent to each other in a time sequence.

For any pulse included in the chopping clock signal, the second pulse and the third pulse are two adjacent pulses that are in the PWM synchronization clock signal and that correspond to a leading edge of the pulse in a time sequence, and the leading edge of the pulse is located between a trailing edge of the second pulse and the leading edge of the third pulse.

The pulse included in the PWM synchronization clock signal may be either at a low level or a high level. In the PWM synchronization clock signal, if the pulse is at a low level, the leading edge of the pulse is a falling edge, and the trailing edge of the pulse is a rising edge. If the pulse is at a high level, the leading edge of the pulse is a rising edge, and the trailing edge of the pulse is a falling edge. The pulse included in the chopping clock signal may be either at a low level or a high level.

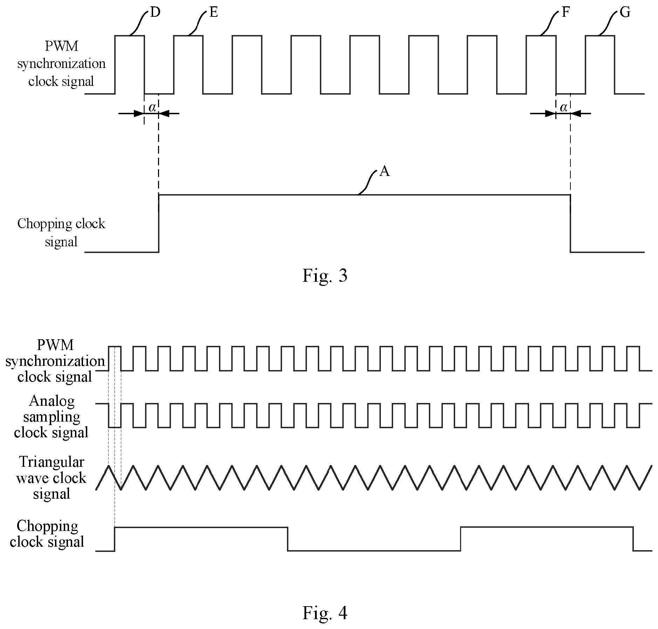

For example, both the pulse included in the chopping clock signal and the pulse included in the PWM synchronization clock signal are at a high level. FIG. 3 shows a schematic diagram of a chopping clock signal and a PWM synchronization clock signal according to an embodiment of the present application. As shown in FIG. 3, the chopping clock signal includes a pulse A, the PWM synchronization clock signal includes a pulse D, and a pulse E. A rising edge of the pulse A is located between a falling edge of the pulse D and a rising edge of the pulse E in a time sequence, and a phase delay of the rising edge of the pulse A relative to the falling edge of the pulse D is α, where 45°≤α≤135°.

It should be noted that the frequency of the PWM synchronization clock signal is an integer multiple of the frequency of the chopping clock signal. When the leading edge of the pulse included in the chopping clock signal is located between the second pulse and the third pulse in a time sequence, the trailing edge of the pulse included in the chopping clock signal is located between two other adjacent pulses included in the PWM synchronization clock signal in a time sequence, and a phase delay of the trailing edge of the pulse included in the chopping clock signal relative to a leading edge of the pulse with a preceding time sequence in the two other adjacent pulses is the same as a phase delay of the leading edge of the pulse included in the chopping clock signal relative to the leading edge of the second pulse, that is, a phase delay of the trailing edge of the pulse included in the chopping clock signal relative to the leading edge of the pulse with the preceding time sequence in the two other adjacent pulses is [45°, 135°].

As shown in FIG. 3, the pulse D and the pulse E are two adjacent pulses in the PWM synchronization clock signal, a pulse F and a pulse G are two adjacent pulses in the PWM synchronization clock signal, and in a time sequence, the pulse E is after the pulse D, the pulse F is after the pulse E, and the pulse G is after the pulse F. The rising edge of the pulse A is located between the falling edge of the pulse D and a rising edge of the pulse E in a time sequence, and the phase delay of the rising edge of the pulse A relative to the falling edge of the pulse D is α. The falling edge of the pulse A is located between a falling edge of the pulse F and a rising edge of the pulse G in a time sequence, and a phase delay of the falling edge of the pulse A relative to the falling edge of the pulse F is α.

In this embodiment of the present application, the leading edge of the pulse included in the chopping clock signal is located between the trailing edge of the second pulse and the leading edge of the third pulse included in the PWM synchronization clock signal in a time sequence, the second pulse and the third pulse are two adjacent pulses in the PWM synchronization clock signal, and the phase delay of the leading edge of the pulse included in the chopping clock signal relative to the leading edge of the second pulse is [45°, 135°]. The PWM synchronization clock signal is used to synchronize the analog differential signal, to ensure that the arrival of the pulse included in the analog differential signal at the input common-mode point and chopping frequency switching of the chopping clock signal do not occur simultaneously, and before the pulse included in the analog differential signal arrives at the input common-mode point, there is enough time to stabilize the intermediate common-mode voltage signal, thereby ensuring a suppression effect on noise and harmonic waves when noise shaping is performed on the analog differential signal.

In a possible implementation, a phase delay of the leading edge of the pulse included in the chopping clock signal relative to the trailing edge of the second pulse is 90°.

The leading edge of the pulse included in the chopping clock signal is located between the trailing edge of the second pulse and the leading edge of the third pulse in the PWM synchronization clock signal in a time sequence. When the leading edge of the pulse included in the chopping clock signal is aligned with the trailing edge of the second pulse in a time sequence, the phase delay of the leading edge of the pulse included in the chopping clock signal relative to the trailing edge of the second pulse is 0, and when the leading edge of the pulse included in the chopping clock signal is aligned with the leading edge of the third pulse in a time sequence, the phase delay of the leading edge of the pulse included in the chopping clock signal relative to the trailing edge of the second pulse is 180°.

As shown in FIG. 3, when the leading edge of the pulse A is aligned with a trailing edge of the pulse D in a time sequence, α is equal to 0, and when the leading edge of the pulse A is aligned with a leading edge of the pulse E in a time sequence, α is equal to 180°.

In this embodiment of the present application, the leading edge of the pulse included in the chopping clock signal is located between the second pulse and the third pulse that are adjacent to each other in the PWM synchronization clock signal in a time sequence, and the phase delay of the leading edge of the pulse included in the chopping clock signal relative to the trailing edge of the second pulse is 90°. Therefore, both a phase difference between the leading edge of the pulse included in the chopping clock signal and the trailing edge of the second pulse and a phase difference between the leading edge of the pulse included in the chopping clock signal and the leading edge of the third pulse are 90°, so that the leading edge of the pulse included in the chopping clock signal has large phase differences with the trailing edge of the second pulse and the leading edge of the third pulse at the same time. In this way, while ensuring that the arrival of the pulse included in the analog differential signal at the input common-mode point and the chopping frequency switching of the chopping clock signal do not occur simultaneously, there is enough time to stabilize the intermediate common-mode voltage signal, thereby avoiding an impedance drop of the input common-mode point, and further ensuring a suppression effect on noise and harmonic waves when noise shaping is performed on the analog differential signal.

In a possible implementation, the chopping clock signal and the PWM synchronization clock signal may be derived from a same clock source. Before chopping processing is performed on the intermediate common-mode voltage signal based on the chopping clock signal to obtain the common-mode voltage signal, frequency division processing may be performed on the PWM synchronization clock signal to obtain a frequency division signal, and then the frequency division signal is resampled based on a resampling clock signal to obtain the chopping clock signal.

By performing frequency division processing on the PWM synchronization clock signal, the frequency division signal can be obtained, and the frequency of the frequency division signal is less than the frequency of the PWM synchronization clock signal. A frequency division ratio of performing frequency division processing on the PWM synchronization clock signal is an integer. In this embodiment of the present application, the frequency division ratio of performing frequency division processing on the PWM synchronization clock signal is not limited. For example, the frequency division ratio may be divide-by-2, divide-by-4, or the like.

By resampling the frequency division signal based on the resampling clock signal, the chopping clock signal can be obtained. By controlling a frequency and a quantity of times of resampling of the resampling clock signal, the phase delay of the leading edge of the pulse in the chopping clock signal relative to the leading edge of the first pulse or the trailing edge of the second pulse can be controlled. The resampling clock signal can be obtained based on the PWM synchronization clock signal. The frequency of the resampling clock signal is greater than the frequency of the PWM synchronization clock signal. For example, the frequency of the resampling clock signal is an integer multiple of the frequency of the PWM synchronization clock signal.

In this embodiment of the present application, after the frequency division signal is obtained by performing frequency division processing on the PWM synchronization clock signal, the frequency division signal is resampled based on the resampling clock signal to obtain the chopping clock signal. That is, the chopping clock signal and the PWM synchronization clock signal are derived from a same clock source, to ensure correct time sequences of a pulse included in the chopping clock signal and a pulse included in the PWM synchronization clock signal, that is, an edge of the pulse in the chopping clock signal is not aligned with an edge of the pulse in the PWM synchronization clock signal in a time sequence, to ensure that the arrival of the pulse included in the analog differential signal at the input common-mode point and the chopping frequency switching of the chopping clock signal do not occur simultaneously, thereby avoiding an impedance drop of the input common-mode point, and further ensuring a suppression effect on noise and harmonic waves when noise shaping is performed on the analog differential signal.

In a possible implementation, when the frequency division signal is resampled to obtain the chopping clock signal, the frequency division signal may be resampled at least once based on the resampling clock signal to obtain the chopping clock signal. The frequency of the resampling clock signal is greater than or equal to 4 times the frequency of the PWM synchronization clock signal.

After the frequency division signal is obtained, the frequency division signal can be resampled based on the resampling clock signal to obtain the chopping clock signal. When the frequency division signal is sampled based on the resampling clock signal to obtain the chopping clock signal, a quantity of times of resampling and the frequency of resampling clock signal determine a phase delay of the leading edge of the pulse in the chopping clock signal relative to the leading edge of the first pulse or the trailing edge of the second pulse in the PWM synchronization clock signal.

The resampling clock signal and the PWM synchronization clock signal may be derived from a same clock source, the frequency of the resampling clock signal is greater than the frequency of the PWM synchronization clock signal, and the frequency of the resampling clock signal may be an integer multiple of the frequency of the PWM synchronization clock signal. For example, the frequency of the resampling clock signal is 4 times, 8 times, or 16 times of the frequency of the PWM synchronization clock signal.

In an example, when the frequency of the resampling clock signal is 4 times the frequency of the PWM synchronization clock signal, if the quantity of times of resampling is 1, the phase delay of the leading edge of the pulse in the chopping clock signal relative to the leading edge of the first pulse in the PWM synchronization clock signal is 90°; or if the quantity of times of resampling is 3, the phase delay of the leading edge of the pulse in the chopping clock signal relative to the trailing edge of the second pulse in the PWM synchronization clock signal is 90°.

In another example, when the frequency of the resampling clock signal is 8 times the frequency of the PWM synchronization clock signal, if the quantity of times of resampling is 1, the phase delay of the leading edge of the pulse in the chopping clock signal relative to the leading edge of the first pulse in the PWM synchronization clock signal is 45°; if the quantity of times of resampling is 2, the phase delay of the leading edge of the pulse in the chopping clock signal relative to the leading edge of the first pulse in the PWM synchronization clock signal is 90°; if the quantity of times of resampling is 3, the phase delay of the leading edge of the pulse in the chopping clock signal relative to the leading edge of the first pulse in the PWM synchronization clock signal is 135°; if the quantity of times of resampling is 5, the phase delay of the leading edge of the pulse in the chopping clock signal relative to the trailing edge of the second pulse in the PWM synchronization clock signal is 45°; if the quantity of times of resampling is 6, the phase delay of the leading edge of the pulse in the chopping clock signal relative to the trailing edge of the second pulse in the PWM synchronization clock signal is 90°; or if the quantity of times of resampling is 7, the phase delay of the leading edge of the pulse in the chopping clock signal relative to the trailing edge of the second pulse in the PWM synchronization clock signal is 135°.

In this embodiment of the present application, when the frequency division signal is resampled based on the resampling clock signal, by controlling the frequency and a quantity of times of resampling of the resampling clock signal, the phase delay of the leading edge of the pulse in the chopping clock signal relative to the leading edge of the first pulse or the trailing edge of the second pulse in the PWM synchronization clock signal can be controlled, to meet a requirement for different phase delays. The frequency of the resampling clock signal is greater than or equal to 4 times the frequency of the PWM synchronization clock signal, so that an edge of a pulse in the chopping clock signal is not aligned with an edge of a pulse in the PWM synchronization clock signal in a time sequence, thereby ensuring a suppression effect on noise and harmonic waves when noise shaping is performed on the analog differential signal.

In a possible implementation, when the frequency division signal is resampled to obtain the chopping clock signal, the resampling clock signal may be delayed, and then the frequency division signal is resampled based on the delayed resampling clock signal to obtain the chopping clock signal.

By delaying the resampling clock signal and resampling the frequency division signal based on the delayed resampling clock signal to obtain the chopping clock signal, a phase delay may be generated at the leading edge of the pulse in the chopping clock signal relative to the leading edge of the first pulse or the trailing edge of the second pulse in the PWM synchronization clock signal. For example, when the frequency of the resampling clock signal is equal to the frequency of the PWM synchronization clock signal and the quantity of times of resampling is 1, if a phase of the resampling clock signal is delayed by 45°, a phase of the leading edge of the pulse in the chopping clock signal relative to the leading edge of the first pulse in the PWM synchronization clock signal may be delayed by 45°; if the phase of the resampling clock signal is delayed by 90°, the phase of the leading edge of the pulse in the chopping clock signal relative to the leading edge of the first pulse in the PWM synchronization clock signal may be delayed by 90°; or if the phase of the resampling clock signal is delayed by 135°, the phase of the leading edge of the pulse in the chopping clock signal relative to the leading edge of the first pulse in the PWM synchronization clock signal may be delayed by 135°.

It should be noted that after the resampling clock signal is delayed, the frequency division signal may be resampled for one or more times based on the delayed resampling clock signal, to adjust the obtained phase delay of the leading edge of the pulse in the chopping clock signal relative to the leading edge of the first pulse or the trailing edge of the second pulse in the PWM synchronization clock signal.

In this embodiment of the present application, because the PWM synchronization clock signal and the resampling clock signal are derived from a same clock source, the resampling clock signal is delayed, and then the frequency division signal is resampled at least once by using the delayed resampling clock signal to obtain the chopping clock signal. In this way, the edge of the pulse included in the chopping clock signal is not aligned with the edge of the pulse in the PWM synchronization clock signal in a time sequence, so that the arrival of the pulse included in the analog differential signal at the input common-mode point and chopping frequency switching do not occur simultaneously, and before the pulse included in the analog differential signal arrives at the input common-mode point, there is certain period of time to stabilize the intermediate common-mode voltage signal, thereby ensuring a suppression effect on noise and harmonic waves when noise shaping is performed on the analog differential signal.

In a possible implementation, when the PWM signal is generated based on the analog differential signal, noise shaping may be performed on the analog differential signal based on an analog sampling clock signal to obtain a PWM input differential signal, and then the PWM input differential signal is compared with a triangular wave clock signal, and the PWM signal is generated based on a comparison result. A frequency of the analog sampling clock signal is the same as the frequency of the PWM synchronization clock signal, a frequency of the triangular wave clock signal is the same as the frequency of the PWM synchronization clock signal, and an inflection point of the triangular wave clock signal is aligned with a rising edge or a falling edge of the pulse included in the PWM synchronization clock signal in a time sequence.

The analog sampling clock signal and the PWM synchronization clock signal may be derived from a same clock source, the frequency of the analog sampling clock signal is the same as the frequency of the PWM synchronization clock signal, and a phase of the analog sampling clock signal may be the same as or opposite to a phase of the PWM synchronization clock signal. As shown in the schematic diagram of a clock signal in FIG. 4, the analog sampling clock signal and the PWM synchronization clock signal have the same frequency and opposite phases.

The triangular wave clock signal and the PWM synchronization clock signal may be derived from a same clock source, the frequency of the triangular wave clock signal is the same as the frequency of the PWM synchronization clock signal, and the inflection point of the triangular wave clock signal is aligned with the rising edge or the falling edge of the pulse in the PWM synchronization clock signal in a time sequence. As shown in FIG. 4, for a first inflection point and a second inflection point that are adjacent to each other in the triangular wave clock signal, if the first inflection point is aligned with the rising edge of the pulse in the PWM synchronization clock signal in a time sequence, the second inflection point is aligned with the falling edge of the pulse in the PWM synchronization clock signal in a time sequence; or if the first inflection point is aligned with the falling edge of the pulse in the PWM synchronization clock signal in a time sequence, the second inflection point is aligned with the rising edge of the pulse in the PWM synchronization clock signal in a time sequence.

When noise shaping is performed on the analog differential signal, the analog differential signal may be filtered by using an analog loop filter (ALF), to filter out high-order harmonic waves in the analog differential signal, and suppress quantization noise generated in a PWM modulation process and noise in an ALF loop, so as to obtain the PWM input differential signal. The analog loop filter includes a sample-and-hold circuit, and the analog sampling clock signal may drive the sample-and-hold circuit to sample and hold an output of the analog loop filter, thereby filtering out high-order harmonic waves output from the ALF, to prevent aliasing during PWM modulation.

The PWM input differential signal may include a positive PWM input differential signal and a negative PWM input differential signal. The positive PWM input differential signal is compared with the triangular wave clock signal, and a PWM positive signal may be generated based on a comparison result. The negative PWM input differential signal is compared with the triangular wave clock signal, and a PWM negative signal may be generated based on a comparison result. The PWM positive signal and the PWM negative signal have the same frequency as the triangular wave clock signal.

In this embodiment of the present application, noise shaping is performed on the analog differential signal based on the analog sampling clock signal, to filter out higher-order PWM modulation harmonic waves in the analog differential signal. Further, the obtained PWM input differential signal is compared with the triangular wave clock signal, to generate a PWM signal and ensure signal quality of the generated PWM signal.

In a possible implementation, the intermediate common-mode voltage signal may be generated based on the common-mode voltage reference signal, and the intermediate common-mode voltage signal is generated in a feedback manner, so that the intermediate common-mode voltage signal approaches the common-mode voltage reference signal. Specifically, a positive voltage signal and a negative voltage signal that are included in a voltage signal of the input common-mode point at a previous moment may be added to obtain a first reference signal, a second reference signal may be obtained by performing 0.5 times amplification processing on the first reference signal, and the second reference signal approaches the common-mode voltage reference signal. A third reference signal may be obtained by performing amplification processing on the second reference signal based on the common-mode voltage reference signal. Further, an intermediate common-mode voltage signal at a current moment may be generated based on the third reference signal, and a common-mode voltage signal at the current moment can be obtained by performing chopping processing on the intermediate common-mode voltage signal at the current moment, so that the common-mode voltage signal approaches the common-mode voltage reference signal. The input common-mode point is a coupling point between the common-mode voltage signal and the analog differential signal.

The common-mode voltage reference signal is a constant-voltage direct current signal, and a voltage value of the common-mode voltage reference signal is equal to a common-mode voltage required by the input common-mode point. For example, the common-mode voltage reference signal is a direct current signal of 2.7 V.

A positive intermediate common-mode voltage signal and a negative intermediate common-mode voltage signal that are included in the intermediate common-mode voltage signal at a previous moment are added to obtain the first reference signal. If the positive intermediate common-mode voltage signal and the negative intermediate common-mode voltage signal at the previous moment are equal to each other, a voltage value of the first reference signal is equal to 2 times that of the positive intermediate common-mode voltage signal (the negative intermediate common-mode voltage signal) at the previous moment.

0.5 times amplification processing is performed on the first reference signal, that is, the voltage value of the first reference signal is reduced by half to obtain the second reference signal. If the positive intermediate common-mode voltage signal and the negative intermediate common-mode voltage signal at the previous moment are equal to each other, a voltage value of the second reference signal is equal to that of the positive intermediate common-mode voltage signal (the negative intermediate common-mode voltage signal) at the previous moment.

In this embodiment of the present application, the positive intermediate common-mode voltage signal and the negative-intermediate common-mode voltage signal at the previous moment are added to obtain the first reference signal, and the first reference signal is amplified by 0.5 times to obtain the second reference signal, so that the second reference signal approaches a common-mode reference signal. The second reference signal is amplified based on the common-mode voltage reference signal to obtain a third reference signal. The third reference signal is amplified by using an amplifier (a second stage of an input common-mode feedback buffer amplifier), to obtain the positive intermediate common-mode voltage signal and the negative intermediate common-mode voltage signal that are included in the common-mode voltage signal at the current moment, so that the intermediate-mode voltage signal approaches the common-mode voltage reference signal, to absorb common-mode feedback currents generated during operation of a chip, thereby ensuring common-mode voltage stability of an input common-mode voltage.

In a possible implementation, the input digital signal may be an audio signal, the output signal may be used to drive a speaker, and the speaker is configured to play the audio signal obtained after signal processing. In an example, the output signal includes a positive output signal and a negative output signal. After filtering processing (for example, LC filtering or low-pass filtering), the positive output signal may be used as a positive end input of the speaker, and after filtering processing (for example, LC filtering or low-pass filtering), the negative output signal may be used as a negative end input of the speaker.

In this embodiment of the present application, the digital audio signal is processed by using the signal processing method in the foregoing embodiments, and by performing chopping processing on the intermediate common-mode voltage signal, flicker noise can be modulated out of an audio frequency band range, to improve a signal-to-noise ratio of the processed audio signal. By controlling the phases of the chopping clock signal and the PWM synchronization clock signal, a suppression effect on noise and harmonic waves when noise shaping is performed on the analog differential signal can be ensured. While ensuring that the processed audio signal includes less noise, the total harmonic distortion plus noise (THDN) of a signal processing circuit that implements the signal processing method in the embodiments of the present application is ensured.

### Signal Processing Circuit

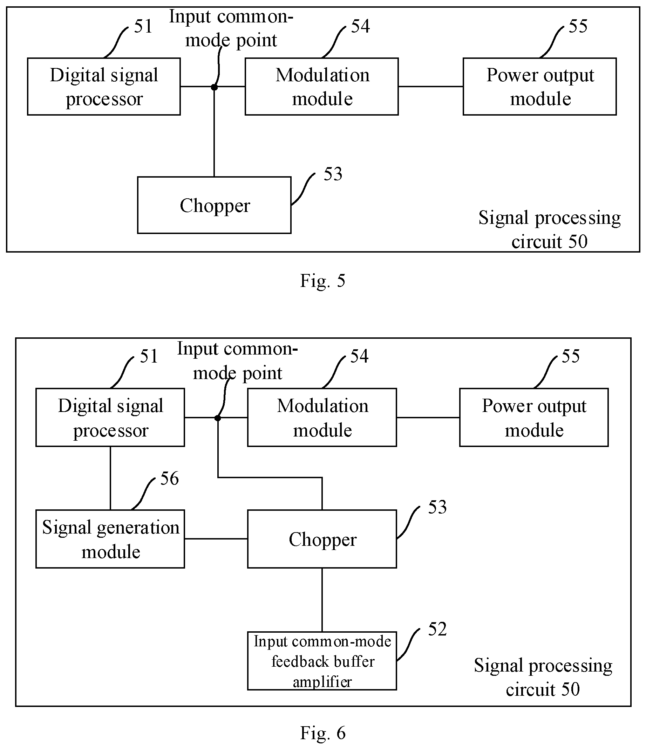

FIG. 5 shows a schematic diagram of a signal processing circuit according to an embodiment of the present application. As shown in FIG. 5, the signal processing circuit 50 includes a digital signal processor 51, a chopper 53, a modulation module 54, and a power output module 55. The digital signal processor 51 can process an input digital signal based on a PWM synchronization clock signal to obtain an analog differential signal. The chopper 53 can perform chopping processing on an intermediate common-mode voltage signal based on a chopping clock signal to obtain a common-mode voltage signal, where the intermediate common-mode voltage signal is used to stabilize a common-mode voltage of the analog differential signal, and an edge of a pulse included in the chopping clock signal is not aligned with an edge of a pulse included in the PWM synchronization clock signal in a time sequence. The modulation module 54 can perform noise shaping and then PWM modulation on the analog differential signal to obtain a PWM signal. The power output module 55 can perform voltage domain conversion on the PWM signal to obtain an output signal.

The digital signal processor 51 can perform preprocessing (noise shaping) on the input digital signal transmitted from an upper computer, convert the input digital signal into an analog differential signal, and input the analog differential signal to the modulation module 54.

In this embodiment of the present application, the digital signal processor 51 processes an input digital signal based on a PWM synchronization clock signal to obtain an analog differential signal, and the chopper 53 performs chopping processing on an intermediate common-mode signal based on a chopping clock signal to obtain a common-mode voltage signal. The common-mode voltage signal can stabilize a common-mode voltage of the analog differential signal, and an edge of a pulse included in the chopping clock signal is not aligned with an edge of a pulse included in the PWM synchronization clock signal in a time sequence. In this way, the arrival of a pulse included in the analog differential signal at an input common-mode point and chopping frequency switching do not occur simultaneously, that is, before the pulse included in the analog differential signal arrives at the input common-mode point, there is a certain period of time to stabilize the intermediate common-mode voltage signal, thereby ensuring a suppression effect of the modulation module 54 on noise and harmonic waves when noise shaping is performed on the analog differential signal. Further, after a PWM signal is obtained by performing PWM modulation on the analog differential signal after noise shaping, the PWM signal includes less noise and harmonic waves, and then after an output signal is obtained by performing, by the power output module 55, voltage domain conversion on the PWM signal, the output signal includes less noise and harmonic waves, to ensure signal processing performance.

In a possible implementation, for the signal processing circuit 50 shown in FIG. 6, the signal processing circuit 50 further includes a signal generation module 56. The signal generation module 56 can perform frequency division processing on the PWM synchronization clock signal to obtain a frequency division signal, and resample the frequency division signal based on a resampling clock signal to obtain the chopping clock signal.

In a possible implementation, as shown in FIG. 6, the signal generation module 56 can resample the frequency division signal at least once based on the resampling clock signal to obtain the chopping clock signal, where a frequency of the resampling clock signal is greater than or equal to 4 times a frequency of the PWM synchronization clock signal.

In a possible implementation, as shown in FIG. 6, the signal generation module 56 can resample the frequency division signal based on the resampling clock signal with a time delay to obtain the chopping clock signal.

In a possible implementation, as shown in FIG. 6, the signal processing circuit 50 may include an input common-mode feedback buffer amplifier 52, and the input common-mode feedback buffer amplifier 52 can generate the intermediate common-mode voltage signal based on a common-mode voltage reference signal.

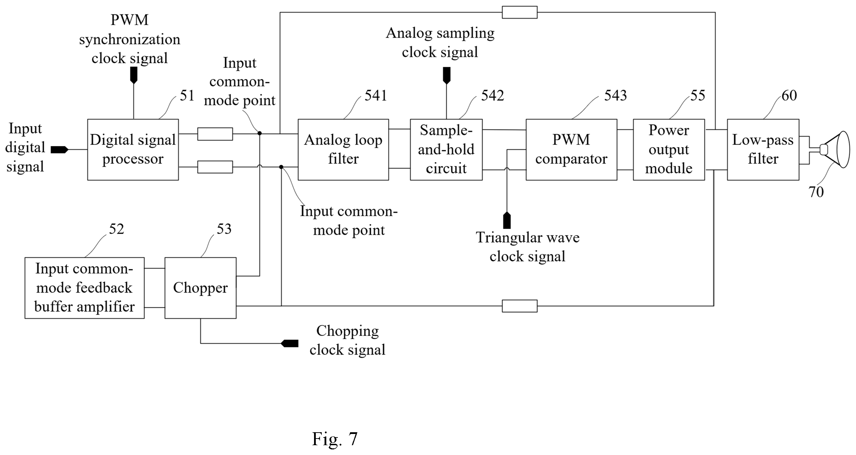

In a possible implementation, for the signal processing circuit 50 shown in FIG. 7, the modulation module 54 includes an analog loop filter 541, a sample-and-hold circuit 542, and a PWM comparator 543.

The analog loop filter 541 can perform noise shaping on the analog differential signal to obtain a PWM input differential signal. The sample-and-hold circuit 542 can hold an output of the analog loop filter 541 based on an analog sampling clock signal, where a frequency of the analog sampling clock signal is the same as a frequency of the PWM synchronization clock signal. The PWM comparator 543 may compare the PWM input differential signal with a triangular wave clock signal, and generate the PWM signal based on a comparison result. A frequency of the triangular wave clock signal is the same as the frequency of the PWM synchronization clock signal, and a rising edge of the triangular wave clock signal is aligned with a rising edge of the pulse included in the PWM synchronization clock signal in a time sequence. The frequency of the triangular wave clock signal is the same as the frequency of the PWM synchronization clock signal, and an inflection point of the triangular wave clock signal is aligned with the rising edge or a falling edge of the pulse included in the PWM synchronization clock signal in a time sequence.

After receiving the input digital signal, the digital signal processor 51 may perform preprocessing (noise shaping) on the input digital signal based on the PWM synchronization clock signal, convert the preprocessed input digital signal into an analog differential signal, and then input the analog differential signal to the analog loop filter 541. In some embodiments, an output of the digital signal processor 51 may be converted into a current input to an input common-mode point by using a resistor between the digital signal processor 51 and the input common-mode point. In some other embodiments, the resistor between the digital signal processor 51 and the input common-mode point may be replaced with a current digital-to-analog converter (IDAC), and the output of the digital signal processor 51 is converted into the current input to the input common-mode point by using the IDAC.

An integrator in the analog loop filter 541 can provide a high audio in-band gain to suppress harmonic waves and noise and improve the total harmonic distortion plus noise. The sample-and-hold circuit 542 can suppress high-order harmonic waves. In one example, the sample-and-hold circuit 542 may be disposed within the analog loop filter 541, that is, the analog loop filter 541 includes the sample-and-hold circuit 542.

The PWM synchronization clock signal is used to synchronize an output signal of the digital signal processor 51, and the chopping clock signal is used to drive the chopper 53. The analog sampling clock signal is used to sample and hold the output of the analog loop filter 541 to filter out the high-order harmonic waves. The triangular wave clock signal is used for PWM modulation.

By disposing the chopper 53 in the signal processing circuit 50, noise of a processed signal can be reduced. The chopper 53 may modulate flicker noise out of an audio frequency band range, to improve a signal-to-noise ratio. Due to mismatch in a manufacturing process, a direct current offset (DC offset) exists at the input common-mode point, and the chopper 53 can reduce the direct current offset at the input common-mode point.

An operating voltage range of a chip includes a low voltage to a high voltage. When the chip operates at the high voltage, large common-mode feedback currents exist. The input common-mode feedback buffer amplifier 52 can absorb these common-mode feedback currents, to ensure common-mode voltage stability at an input point of the analog loop filter 541. A stable common-mode voltage can ensure that the output of the digital signal processor 51 is input to the analog loop filter 541 with a small loss, thereby improving signal processing performance.

It should be noted that a phase difference between the PWM synchronization clock signal and the analog sampling clock signal is adjustable, and a phase lag of the analog sampling clock signal or a phase ahead of the PWM synchronization clock signal may be configured, and specifically may be adjusted based on an actual situation and signal magnitude. The phase difference between the PWM synchronization clock signal and the analog sampling clock signal can be controlled digitally.

It should be noted that the digital signal processor 51, the input common-mode feedback buffer amplifier 52, the chopper 53, the analog loop filter 541, the sample-and-hold circuit 542, the PWM comparator 543, and the power output module 55 in FIG. 7 may be included in the chip, and a low-pass filter 60 and a speaker 70 are disposed outside the chip. After the power output module 55 inputs the output signal to the low-pass filter 60, the low-pass filter 60 may perform filtering processing (for example, LC filtering or low-pass filtering) on the output signal, and then transmit the output signal after the filtering processing to the speaker 70 to drive the speaker 70 to operate.

The edge of the pulse in the chopping clock signal is not aligned with the edge of the pulse included in the PWM synchronization clock signal in a time sequence, that is, the chopping clock signal and the PWM synchronization clock signal are staggered. The digital signal processor 51 outputs a pulse to the input common-mode point of the analog loop filter 541 at a leading edge of the PWM synchronization clock signal, and the input common-mode feedback buffer amplifier 52 receives the input common-mode point of the analog loop filter 541. When the chopping frequency is switched at a clock edge, the input common-mode feedback buffer amplifier 52 needs time to maintain stability. If the occurrence of chopping frequency switching collides with the pulse output by the digital signal processor 51, and the input common-mode feedback buffer amplifier 52 is not stable in this case, a decrease of an impedance of the input common-mode point of the analog loop filter 541 is caused, thereby reducing suppression on noise and harmonic waves by the analog loop filter 541, and further reducing signal processing performance. If the chopping clock signal and the PWM synchronization clock signal are staggered by a specific phase, so that edges of the chopping clock signal and the PWM synchronization clock signal do not collide with each other, before the pulse output by the digital signal processor 51 arrives at the input common-mode point of the analog loop filter 541, a certain period of time is reserved for stabilizing the output of the input common-mode feedback buffer amplifier 52, thereby ensuring a suppression effect of the analog loop filter 541 on noise and harmonic waves.

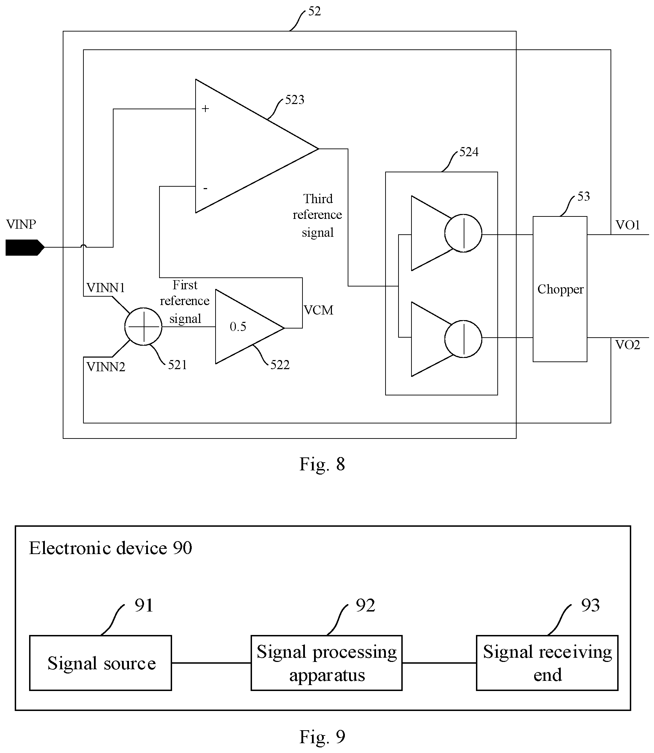

In a possible implementation, for the input common-mode feedback buffer amplifier 52 shown in FIG. 8, the input common-mode feedback buffer amplifier 52 can generate the intermediate common-mode voltage signal based on the common-mode voltage reference signal. The input common-mode feedback buffer amplifier 52 includes an adder 521, a first amplifier 522, a second amplifier 523, and a third amplifier 524.

The adder 521 can add a positive intermediate common-mode voltage signal VINN1 and a negative intermediate common-mode voltage signal VINN2 that are included in a voltage signal of the input common-mode point at a previous moment to obtain a first reference signal, where the input common-mode point is a connection point between the chopper 53 and the analog loop filter 541. The first amplifier 522 can perform 0.5 times amplification processing on the first reference signal to obtain a second reference signal VCM, where the magnitude of the second reference signal VCM approaches that of a common-mode voltage reference signal VINP. The second amplifier 523 can perform amplification processing on the second reference signal VCM based on the common-mode voltage reference signal VINP to obtain a third reference signal. The third amplifier 524 can perform amplification processing on the third reference signal to generate an intermediate common-mode voltage signal at a current moment, and the chopper 53 performs chopping processing on the intermediate common-mode voltage signal to obtain a common-mode voltage signal, so that a positive common-mode voltage signal VO1 and a negative common-mode voltage signal VO2 included in the common-mode voltage signal approach the common-mode voltage reference signal VINP.

The third amplifier 524 may be a second stage of the input common-mode feedback buffer amplifier, and the third amplifier 524 can perform amplification processing on the third reference signal to obtain a positive intermediate common-mode voltage signal and a negative intermediate common-mode voltage signal that are included in the intermediate common-mode voltage signal, where the positive intermediate common-mode voltage signal and the negative intermediate common-mode voltage signal are the same. The chopper 53 can perform chopping processing on the positive intermediate common-mode voltage signal and the negative intermediate common-mode voltage signal to obtain the intermediate common-mode voltage signal, where the positive common-mode voltage signal VO1 and the negative common-mode voltage signal VO2 that are included in the intermediate common-mode voltage signal approach the common-mode voltage reference signal VINP.

It should be noted that the signal processing circuit in this embodiment of the present application is configured to perform the signal processing method in the foregoing embodiments, and is based on the same concept as the foregoing embodiments of the signal processing method. For specific content and beneficial effects, refer to the description in the foregoing embodiments of the signal processing method. Details are not described herein again.

### Signal Processing Chip

An embodiment of the present application provides a signal processing chip. The signal processing chip is configured to perform the signal processing method in any one of the foregoing embodiments. The signal processing chip may include the signal processing circuit 50 in any one of the foregoing embodiments. That is, the signal processing circuit 50 in the foregoing embodiments is encapsulated in the signal processing chip. The signal processing chip may be disposed in an electronic device that has a signal processing requirement for processing an audio signal or a power supply signal, and is configured to perform signal processing.

It should be noted that the signal processing chip in this embodiment of the present application is configured to perform the signal processing method in the foregoing embodiments, and is based on the same concept as the foregoing signal processing method embodiments. For specific content and beneficial effects, refer to the description in the foregoing embodiments of the signal processing method. Details are not described herein again.

### Electronic Device

FIG. 9 shows a schematic diagram of an electronic device according to an embodiment of the present application. As shown in FIG. 9, the electronic device 90 includes a signal source 91, a signal processing apparatus 92, and a signal receiving end 93. The signal processing apparatus 92 may include the signal processing circuit 50 or the signal processing chip in any one of the foregoing embodiments.

The signal processing apparatus 92 is connected between the signal source 91 and the signal receiving end 93, the signal source 91 is configured to transmit an input digital signal to the signal processing apparatus 92, and the signal receiving end 93 is configured to receive an output signal output by the signal processing apparatus 92.

The input digital signal transmitted by the signal source 91 to the signal processing apparatus 92 may be a digital audio signal. After receiving the output signal, the signal receiving end 93 may perform LC filtering on the output signal and transmit the output signal after the LC filtering to a speaker, to drive the speaker to sound.

It should be noted that the electronic device in this embodiment of the present application is implemented based on the signal processing circuit 50 or the signal processing chip in the foregoing embodiments, and is a specific application of the signal processing circuit 50 and the signal processing chip in the foregoing embodiments. For specific content and beneficial effects, refer to the description in the foregoing embodiments of the signal processing unit and the signal processing chip. Details are not described herein again.

It should be understood that the embodiments of this specification are described in a progressive way. For same or similar parts in the embodiments, refer to each other. Each embodiment focuses on a difference from the other embodiments. Particularly, the method embodiment is basically similar to the method described in the apparatus and system embodiments, and therefore is briefly described. For a related part, refer to some descriptions in other embodiments.

It should be understood that specific embodiments of this specification are described above. Other embodiments fall within the scope of the claims. In some cases, the actions or steps described in the claims can be performed in a sequence different from that in the embodiments and desired results can still be achieved. In addition, the process depicted in the accompanying drawings does not necessarily need a shown particular sequence or consecutive sequence to achieve the desired results. In some implementations, multitasking and parallel processing are possible or may be advantageous.

It should be understood that an element described in a singular form or the display of only one element in the accompanying drawings in this specification does not mean that the quantity of the elements is limited to one. In addition, separate modules or elements described or shown in this specification may be combined into a single module or element, and a single module or element described or shown in this specification may be split into a plurality of modules or elements.

It should also be understood that terms and expressions used in this specification are merely used for description, and one or more embodiments of this specification are not limited to these terms and expressions. The use of these terms and expressions does not mean excluding any schematic and described equivalent features (or parts thereof), and it should be recognized that various possible modifications should fall within the scope of the claims. Other modifications, changes, and replacements may also exist. Accordingly, the claims shall be deemed to cover all these equivalents.

## Claims

1. A signal processing method, **characterized by** comprising:
processing an input digital signal based on a PWM synchronization clock signal to obtain an analog differential signal;
performing chopping processing on an intermediate common-mode voltage signal based on a chopping clock signal to obtain a common-mode voltage signal, wherein the intermediate common-mode voltage signal is used to stabilize a common-mode voltage of the analog differential signal, and an edge of a pulse comprised in the chopping clock signal is not aligned with an edge of a pulse comprised in the PWM synchronization clock signal in a time sequence;
performing noise shaping and then PWM modulation on the analog differential signal to obtain a PWM signal; and
performing voltage domain conversion on the PWM signal to obtain an output signal.

2. The method according to claim 1, wherein
a leading edge of the pulse comprised in the chopping clock signal is located between a leading edge and a trailing edge of a first pulse comprised in the PWM synchronization clock signal in a time sequence, and a phase delay of the leading edge of the pulse comprised in the chopping clock signal relative to the leading edge of the first pulse is [45°, 135°].

3. The method according to claim 2, wherein the phase delay of the leading edge of the pulse comprised in the chopping clock signal relative to the leading edge of the first pulse is 90°.

4. The method according to claim 1, wherein a leading edge of the pulse comprised in the chopping clock signal is located between a trailing edge of a second pulse and a leading edge of a third pulse comprised in the PWM synchronization clock signal in a time sequence, and a phase delay of the leading edge of the pulse comprised in the chopping clock signal relative to the trailing edge of the second pulse is [45°, 135°], wherein the second pulse and the third pulse are pulses with adjacent time sequences in the PWM synchronization clock signal.

5. The method according to claim 4, wherein the phase delay of the leading edge of the pulse comprised in the chopping clock signal relative to the trailing edge of the second pulse is 90°.

6. The method according to claim 1, wherein the method further comprises:
performing frequency division processing on the PWM synchronization clock signal to obtain a frequency division signal; and
resampling the frequency division signal based on a resampling clock signal to obtain the chopping clock signal.

7. The method according to claim 6, wherein the resampling the frequency division signal based on a resampling clock signal to obtain the chopping clock signal comprises:
resampling the frequency division signal at least once based on the resampling clock signal to obtain the chopping clock signal, wherein a frequency of the resampling clock signal is greater than or equal to 4 times a frequency of the PWM synchronization clock signal.

8. The method according to claim 6, wherein the resampling the frequency division signal based on a resampling clock signal to obtain the chopping clock signal comprises:
resampling the frequency division signal based on the resampling clock signal with a time delay to obtain the chopping clock signal.

9. The method according to claim 1, wherein the performing noise shaping and then PWM modulation on the analog differential signal to obtain a PWM signal comprises:
performing noise shaping on the analog differential signal based on an analog sampling clock signal to obtain a PWM input differential signal, wherein a frequency of the analog sampling clock signal is the same as a frequency of the PWM synchronization clock signal; and
comparing the PWM input differential signal with a triangular wave clock signal, and generating the PWM signal based on a comparison result, wherein a frequency of the triangular wave clock signal is the same as the frequency of the PWM synchronization clock signal, and an inflection point of the triangular wave clock signal is aligned with a rising edge or a falling edge of the pulse comprised in the PWM synchronization clock signal in the time sequence.

10. The method according to claim 1, wherein the method further comprises: generating the intermediate common-mode voltage signal based on a common-mode voltage reference signal; and
the generating the intermediate common-mode voltage signal based on a common-mode voltage reference signal comprises:
adding a positive intermediate common-mode voltage signal and a negative intermediate common-mode voltage signal that are comprised in a voltage signal of an input common-mode point at a previous moment to obtain a first reference signal, wherein the input common-mode point is a coupling point between the common-mode voltage signal and the analog differential signal;
performing 0.5 times amplification processing on the first reference signal to obtain a second reference signal, wherein the second reference signal approaches the common-mode voltage reference signal;
performing amplification processing on the second reference signal based on the common-mode voltage reference signal to obtain a third reference signal; and
generating an intermediate common-mode voltage signal at a current moment based on the third reference signal, so that the common-mode voltage signal obtained by performing chopping processing on the intermediate common-mode voltage signal at the current moment approaches the common-mode voltage reference signal.

11. The method according to any one of claims 1 to 10, wherein the input digital signal is a digital audio signal, the output signal is used to drive a speaker, and the speaker is configured to play the digital audio signal obtained after signal processing.

12. A signal processing circuit, **characterized by** comprising:
a digital signal processor, configured to process an input digital signal based on a PWM synchronization clock signal to obtain an analog differential signal;
a chopper, configured to perform chopping processing on an intermediate common-mode voltage signal based on a chopping clock signal to obtain a common-mode voltage signal, wherein the intermediate common-mode voltage signal is used to stabilize a common-mode voltage of the analog differential signal, and an edge of a pulse comprised in the chopping clock signal is not aligned with an edge of a pulse comprised in the PWM synchronization clock signal in a time sequence;
a modulation module, configured to perform noise shaping and then PWM modulation on the analog differential signal to obtain a PWM signal; and
a power output module, configured to perform voltage domain conversion on the PWM signal to obtain an output signal.

13. The circuit according to claim 12, wherein the circuit further comprises:
a signal generation module, configured to perform frequency division processing on the PWM synchronization clock signal to obtain a frequency division signal, and resample the frequency division signal based on a resampling clock signal to obtain the chopping clock signal.

14. The circuit according to claim 13, wherein the signal generation module is configured to
resample the frequency division signal at least once based on the resampling clock signal to obtain the chopping clock signal, wherein a frequency of the resampling clock signal is greater than or equal to 4 times a frequency of the PWM synchronization clock signal.

15. The circuit according to claim 13, wherein the signal generation module is configured to resample the frequency division signal based on the resampling clock signal with a time delay to obtain the chopping clock signal.

16. The circuit according to claim 12, wherein the modulation module comprises:
an analog loop filter, configured to perform noise shaping on the analog differential signal to obtain a PWM input differential signal;
a sample-and-hold circuit, configured to hold an output of the analog loop filter based on an analog sampling clock signal, wherein a frequency of the analog sampling clock signal is the same as a frequency of the PWM synchronization clock signal; and
a PWM comparator, configured to compare the PWM input differential signal with a triangular wave clock signal, and generate the PWM signal based on a comparison result, wherein a frequency of the triangular wave clock signal is the same as the frequency of the PWM synchronization clock signal, and an inflection point of the triangular wave clock signal is aligned with a rising edge or a falling edge of the pulse comprised in the PWM synchronization clock signal in the time sequence.

17. The circuit according to any one of claims 12 to 16, wherein the signal processing circuit comprises an input common-mode feedback buffer amplifier, and the input common-mode feedback buffer amplifier comprises:
an adder, configured to add a positive intermediate common-mode voltage signal and a negative intermediate common-mode voltage signal that are comprised in a voltage signal of an input common-mode point at a previous moment to obtain a first reference signal, wherein the input common-mode point is a connection point between the chopper and the analog loop filter;
a first amplifier, configured to perform 0.5 times amplification processing on the first reference signal to obtain a second reference signal, wherein the second reference signal approaches a common-mode voltage reference signal;
a second amplifier, configured to perform amplification processing on the second reference signal based on the common-mode voltage reference signal to obtain a third reference signal; and
a third amplifier, configured to perform amplification processing on the third reference signal to generate an intermediate common-mode voltage signal at a current moment, so that the common-mode voltage signal obtained by performing chopping processing on the intermediate common-mode voltage signal at the current moment approaches the common-mode voltage reference signal.

18. A signal processing chip, **characterized in that** the signal processing chip is configured to perform the method according to any one of claims 1 to 11.

19. An electronic device, **characterized by** comprising a signal source, a signal receiving end, and a signal processing apparatus, wherein the signal processing apparatus comprises the signal processing circuit according to any one of claims 12-17 or the signal processing chip according to claim 18;
the signal processing apparatus is connected between the signal source and the signal receiving end;
the signal source is configured to transmit an input digital signal to the signal processing apparatus; and
the signal receiving end is configured to receive an output signal output by the signal processing apparatus.
